# FASCICULE DE BREVET EUROPEEN

(11) **EP 0 787 222 B1**
(45) Date de publication et mention de la délivrance du brevet: **08.08.2001**
(21) Numéro de dépôt: 95939327.3
(22) Date de dépôt: 06.11.1995
(51) Int. Cl.: C23C 16/26, C23C 16/50, C23C 16/34, C23C 16/36, C23C 14/06

(54) **PROCEDE DE DEPOT D'UN REVETEMENT PROTECTEUR DE GRANDE DURETE**
VERFAHREN ZUR HERSTELLUNG EINER HARTSTOFFSCHUTZSCHICHT
METHOD FOR DEPOSITING A HARD PROTECTIVE COATING

(30) Priorité: 07.11.1994 FR 9413323
(43) Date de publication de la demande: 06.08.1997
(73) Titulaire: PLASMA INNOVATION, 93290 Tremblay en France (FR)
(72) Inventeur: NEUVILLE, Stéphane, 77230 Montge-en-Goele (FR)
(74) Mandataire: Cabinet HERRBURGER
(86) Numéro de dépôt international: FR9501455
(87) Numéro de publication internationale: WO9614448

(56) Documents cités:
- EP-A- 0 244 874
- EP-A- 0 284 190
- EP-A- 0 510 567
- DE-A- 3 941 202
- US-A- 5 013 579
- 7TH INTERNATIONAL CONFERENCE ON THIN FILMS, NEW DELHI, INDIA, 7-11 DEC. 1987, ISSN 0040-6090, THIN SOLID FILMS, SEPT. 1988, SWITZERLAND, AIYER C R ET AL 'Effect of mixing oxygen or diborane on the formation of amorphous carbon films from methane by RF plasma chemical vapour deposition'
- FIFTEENTH IUPAP INTERNATIONAL CONFERENCE ON AMORPHOUS SEMICONDUCTORS: SCIENCE AND TECHNOLOGY, CAMBRIDGE, UK, 6-10 SEPT. 1993, JOURNAL OF NON-CRYSTALLINE SOLIDS, DEC. 1993, NETHERLANDS, AMARATUNGA G A J ET AL 'Doping of highly tetrahedral amorphous carbon'
- PATENT ABSTRACTS OF JAPAN vol. 004 no. 026 (C-001) ,6 Mars 1980 & JP,A,55 002715 (MITSUBISHI METAL CORP) 10 Janvier 1980,
- PATENT ABSTRACTS OF JAPAN vol. 009 no. 211 (C-300) ,29 Août 1985 & JP,A,60 075579 (TOSHIBA KK) 27 Avril 1985,
- LE VIDE, vol. 41, no. 230, 1 Janvier 1986 FR, pages 65-69, H. MICHEL ET AL 'ANALYSE DE LA TEXTURE DE COUCHES MINCES DE TITANE ET DE NITRURE DE TITANE OBTENUES PAR P.V.D.'
- PATENT ABSTRACTS OF JAPAN vol. 012 no. 387 (C-536) ,14 Octobre 1988 & JP,A,63 134661 (SUMITOMO ELECTRIC IND LTD) 7 Juin 1988,
- 4TH EUROPEAN CONFERENCE ON DIAMOND, DIAMOND-LIKE AND RELATED MATERIALS (DIAMOND FILMS '93), ALBUFEIRA, PORTUGAL, 20-24 SEPT. 1993, vol. 3, no. 4-6, ISSN 0925-9635, DIAMOND AND RELATED MATERIALS, APRIL 1994, SWITZERLAND, pages 337-340, XP 000466663 DWORSCHAK W ET AL 'Growth of cubic boron nitride coatings in a magnetic field enhanced r.f. glow discharge'
- DIAMOND AND RELATED MATERIALS, FEB. 1995, SWITZERLAND, vol. 4, no. 2, ISSN 0925-9635, pages 113-119, XP 000511963 KULIKOVSKY V YU ET AL 'Preparation of thin hard boron nitride films by r.f. magnetron sputtering'

## Description

La présente invention concerne un procédé de dépôt sur au moins une pièce d'un revêtement protecteur de grande dureté.

Ce revêtement peut être constitué par un revêtement de type pseudo carbone diamant amorphe à base de carbone et d'azote, ou, à titre de variante, par un revêtement à base de titane, d'azote et de carbone de type TiCN, ou encore par un revêtement en nitrure de bore (BN).

Dans tous les cas, ces revêtements doivent être suffisamment durs, stables thermiquement et adhérents.

Pour augmenter la résistance à l'usure par frottement ou à l'abrasion des pièces mécaniques, notamment celles appelées à subir de fortes contraintes, ou encore les protéger contre la corrosion, on a cherché depuis plusieurs décennies, à proposer des revêtements de protection parmi lesquels on peut, à titre d'exemple, mentionner les couches de nitrure de titane ou celles obtenues par nitruration.

Malgré leur qualité intrinsèque, de telles couches ne se sont pas toujours montrées aptes à donner entière satisfaction, particulièrement dans le cas de pièces destinées à résister à des sollicitations très élevées, notamment pièces de moules, pièces d'usure mécaniques, ... en particulier par suite d'une adhérence insuffisante surtout sur les parties anguleuses.

Pour résoudre ces problèmes, les chercheurs ont déjà proposé des revêtements de dureté variable dits de pseudo carbone diamant amorphe contenant essentiellement du carbone et de l'hydrogène en proportions variables, et le cas échéant, des agents dopants tels que le silicium, l'azote, le fluor, le bore ou encore des métaux tels que le titane ou l'argent.

Ces revêtements ou des revêtements analogues tels que le carbure ou le nitrure de titane, le carbure ou le nitrure de bore ... qui ont des stabilités thermiques variables de 400°C à 1 000°C, peuvent être obtenus par la mise en oeuvre de différentes techniques parmi lesquelles on peut noter les techniques dérivées de la technique connue sous la dénomination CVD (Chemical Vapour Deposition), c'est-à-dire condensation de vapeur par voie chimique.

Dans la technique CVD classique, on introduit un gaz précurseur contenant notamment un ou plusieurs hydrocarbures dans une enceinte dans laquelle se trouvent les pièces à revêtir que l'on élève à une température de l'ordre de 800 à 1 500°C. A ces températures, les gaz introduits peuvent réagir chimiquement les uns avec les autres et conduire à la formation d'une couche mince solide qui se condense sur les pièces chaudes.

Avec des techniques dérivées de la technique CVD classique à haute température, il est possible, en présence d'un excès d'hydrogène dissocié (en particulier à l'aide d'un filament chaud ou bien en présence d'une décharge électrique réalisée à haute pression dans laquelle il n'y a pas de bombardement ionique) de déposer des couches dites de carbone diamant polycristallin ayant une structure tétraédrique largement similaire à celle du diamant et qui sont essentiellement exemptes d'hydrogène (par suite de la recombinaison et de l'élimination de l'hydrogène).

Cette technique, en ce qui concerne le carbone diamant polycristallin, ne permet pas néanmoins de réaliser des dépôts très adhérents, en particulier par suite de l'existence de fortes contraintes thermiques, et ne peut cependant être utilisée que pour des matériaux durs ou des céramiques susceptibles de résister à des températures de 800 à 1 500°C.

Pour généraliser l'utilisation de cette technique, les spécialistes ont mis au point la technique dite « PECVD » (Plasma Enhanced Chemical Vapour Deposition) ou « CVD assisté plasma » dans laquelle la température peut être abaissée dans une large mesure.

Une telle technique de revêtement est mise en oeuvre dans une chambre à vide associée à un système de pompes et renfermant un support métallique relié à un générateur puissant sur lequel sont posées les pièces que l'on souhaite revêtir. Le générateur peut délivrer un courant continu ou alternatif travaillant dans le domaine des radiofréquences (13,56 MHz) ou des micro-ondes (2,45 GHz) pour permettre d'apporter à l'intérieur de la chambre l'énergie nécessaire à l'entretien d'une décharge électrique de tension de l'ordre de 10 à 1 000 V, ce qui par ailleurs élève la température du support métallique et de la pièce à traiter à une valeur de 150 à 400 C lorsque le dépôt dépasse 1 *µ* d'épaisseur.

Lors de la mise en oeuvre de cette technique, on amène préalablement la chambre à vide à une pression de l'ordre de 10⁻⁴ à 10⁻⁶ mbars et on introduit, à des pressions de l'ordre de 5 10⁻³ à 1 mbar un gaz précurseur contenant un ou plusieurs hydrocarbures ainsi que le cas échéant des agents dopants ; des vannes doseuses permettent de régler les quantités respectives de gaz introduites dans la chambre.

Dans les conditions de pression et de puissance électrique régnant à l'intérieur de cette dernière, on peut ainsi exciter physiquement et chimiquement le gaz précurseur et le ioniser de sorte que les atomes perdent partiellement leurs électrons en se transformant en particules positives : on est alors en présence d'un plasma qui se reconnaît à sa lueur spécifique. Cette transformation a pour corollaire un « craquage » du mélange gazeux en atomes élémentaires et radicaux hydrocarbonés qui se déposent sur la pièce par condensation et bombardement ionique, sous forme de carbone solide hydrogéné ; on peut ainsi obtenir un revêtement protecteur de type pseudo carbone diamant amorphe qui est, en fait, constitué par l'association de structures tétraédriques de type diamant, de structures graphitiques et de structures correspondant à du carbone hydrogéné.

De manière plus précise, il est connu que le plasma est constitué par un mélange de radicaux neutres non ionisés mais activés et de particules ioniques positives ayant perdu leurs électrons. Par suite de leur très grande réactivité chimique, les radicaux neutres viennent adhérer sur la surface du support et de la pièce avec un coefficient de « collage » de 0,01 à 1 tandis que les particules ioniques viennent compacter le dépôt ainsi formé.

En effet, parallèlement aux transformations susmentionnées, le support métallique se charge lui même négativement par rapport au plasma tout comme la pièce à revêtir et exerce, par suite, une force d'attraction sur les particules ioniques positives présentes dans le plasma ; celles-ci sont donc accélérées en direction de la pièce et le dépôt est soumis à un bombardement d'ions pendant sa croissance.

Or, ce bombardement est un facteur très important, en particulier compte tenu du fait que, dans une sphère qui a pour centre le point d'impact de chaque ion, les atomes présents dans le revêtement en formation sont soumis à des chocs importants et à des pressions très fortes qui les compriment avant d'être relaxées ; ceci produit des déplacements atomiques qui peuvent faciliter la réalisation d'une structure dense.

Le processus susmentionné permet d'obtenir le dépôt d'une couche mince d'un revêtement en un matériau particulièrement dur et dense. Ces revêtements présentent toutefois un certain nombre de défauts parmi lesquels on peut noter leur instabilité thermique à des températures supérieures à 400-500°C ainsi que leur faible adhérence et leur fragilité induisant notamment des risques d'écaillement.

De nombreux chercheurs ont tenté de remédier aux inconvénients susmentionnés, notamment en ajoutant au gaz précurseur, différents types d'agents dopants. Parmi les tentatives les plus prometteuses, on peut noter celles décrites dans les documents FR-91 04 896 et FR-91 13 017 qui ont consisté à proposer d'ajouter au gaz carboné des composés siliciés ainsi que du bore et de l'azote, en particulier sous la forme d'une molécule carbonée borée et azotée ayant le même nombre d'atomes d'azote et d'atomes de bore.

Ces tentatives n'ont cependant pas eu le succès espéré, et en conséquence, la technique PECVD du carbone amorphe hydrogéné ne connaît pas sur le plan industriel le développement auquel on aurait pu s'attendre et ces revêtements sont actuellement en général délaissés au profit des revêtements à base de nitrure de titane qui sont bien moins durs mais donnent d'excellents résultats sur les outils de coupe et d'estampage.

La présente invention a pour objet de remédier à ces inconvénients en proposant un procédé permettant de déposer sur une pièce et par la technique PECVD un revêtement protecteur de type pseudo carbone diamant amorphe à la fois dur, stable thermiquement et adhérent.

Pour concevoir ce procédé, on a eu l'idée, conformément à l'invention, de mettre en pratique une théorie connue dite de Liu et Cohen selon laquelle il serait possible d'obtenir un composé C₃N₄ ayant une structure largement identique à celle de Si₃N₄, tout en étant plus dur que le diamant. Personne n'avait cependant jusqu'à présent réussi à fabriquer un tel composé, en particulier par la technique PECVD.

Pour obtenir un tel composé, il est en effet nécessaire de faire réagir le carbone et l'azote ; une telle réaction s'avère cependant extrêmement difficile à mettre en oeuvre, compte tenu du fait que l'azote doit être fortement dissocié et en outre ne pas pouvoir entrer en compétition avec l'hydrogène, ce qui exclut en théorie de faire appel à un gaz précurseur hydrocarboné et d'y ajouter de l'azote.

L'invention a néanmoins pour objet un procédé permettant de déposer sur au moins une pièce un tel revêtement protecteur à base de carbone et d'azote par la technique dite PECVD.

Pour qu'un tel revêtement puisse donner satisfaction, il est impératif qu'il ait une structure à dominante tétraédrique de type diamant et que celle-ci ne soit pas polymérique, c'est-à-dire qu'il soit exempt d'hydrogène.

En effet, la présence d'hydrogène dans un tel revêtement entraîne quatre conséquences fondamentales qui sont toutes néfastes :
- les éléments hydrogénés implantés dans les couches entraînent des contraintes qui ont pour conséquence un éclatement et un délaminage de celles-ci,
- on a pu constater que lorsque l'on chauffe les revêtements classiques à base de pseudo carbone diamant amorphe, l'hydrogène s'en échappe par thermodiffusion, d'où il résulte une graphitisation des couches,
- la présence d'hydrogène contribue en outre fortement aux problèmes d'adhérence : il s'agit en effet là d'un atome monovalent comportant deux électrons ; un hydrogène terminal constitue par suite une branche « morte » qui ne peut contribuer aux liaisons covalentes interfaciales,
- l'hydrogène empêche la constitution des sites tétraédriques non hydrogénés qui sont à l'origine de la dureté.

Cet effet néfaste de l'hydrogène fait que pour être satisfaisant, un revêtement protecteur déposé par la technique PECVD doit impérativement être exempt d'hydrogène.

Or, l'invention propose un procédé permettant d'obtenir un tel dépôt de type pseudo carbone diamant amorphe dur et déshydrogéné, ce sans passer par la chimie des plasmas à haute température, comme c'est le cas pour les dépôts de carbone diamant polycristallin.

Conformément à ce procédé, on introduit un gaz précurseur renfermant les éléments à déposer ainsi que des agents dopants dans une chambre à vide renfermant un support métallique relié à un générateur puissant de courant continu ou alternatif travaillant dans le domaine des radiofréquences ou des micro-ondes et sur lequel se trouve la pièce à revêtir et on entretient une décharge électrique à l'intérieur de la chambre de façon à élever la température de la pièce à une valeur de 150 à 400°C lorsque l'épaisseur du dépôt dépasse 1 *µ*, et dans des conditions de température, de puissance et de pression permettant l'excitation physique et chimique du gaz précurseur et son ionisation sous forme de plasma de façon à provoquer le dépôt, par bombardement ionique sur la pièce d'un revêtement protecteur de grande dureté de type pseudo carbone diamant amorphe.

Selon l'invention, ce procédé est caractérisé en ce que le gaz précurseur contient entre 10 et 70 % d'azote associé à un ou plusieurs hydrocarbures faisant office de gaz fournisseur d'hydrogène dissocié au sein du plasma, ainsi que 0,5 à 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN, on ajoute à ce gaz précurseur entre 10 et 70 % d'un mélange d'hélium et d'argon ou entre 10 et 70 % de néon dont le rôle est d'exciter fortement et de dissocier simultanément l'azote et l'hydrogène, et on choisit l'énergie apportée à chaque atome du gaz précurseur de façon à se placer dans des conditions qui définissent la plage d'énergie pour laquelle on obtient un maximum de structures tétraédriques de type diamant aux dépens de structures hexagonales de type graphitique.

Il est à noter que l'adhérence d'un tel dépôt peut être amplifiée par l'usage d'une précouche qui améliore l'énergie d'adhérence interfaciale, telle que carbure de silicium ou carbure de germanium déshydrogéné.

Le paramètre essentiel du procédé conforme à l'invention est lié à l'addition d'une proportion notable de gaz rares au gaz précurseur, ces gaz rares peuvent être constitués soit par un mélange d'hélium et d'argon, soit par du néon.

On a, en effet, pu établir que de tels gaz rares peuvent agir selon trois mécanismes différents dont le premier consiste à augmenter la mobilité des atomes d'hydrogène présents à la surface de la pièce permettant ainsi leur regroupement et la reconstitution de molécules H2 qui peuvent s'échapper.

Le second mécanisme d'action des gaz rares consiste à favoriser la dissociation de l'azote et de l'hydrogène suite à leur bombardement. Il est essentiel de noter que dans un plasma, l'hélium a la capacité de dissocier très fortement l'azote mais n'a aucune action sur l'hydrogène alors qu'au contraire et sans que l'on sache pour quelle raison, l'argon dissocie fortement l'hydrogène mais que très peu l'azote ; le néon, dont la masse moléculaire est intermédiaire entre celle de l'hélium et celle de l'argon, permet de dissocier à la fois l'azote et l'hydrogène dans un plasma : on a en effet pu constater qu'il dissocie l'azote mieux que l'argon et l'hydrogène mieux que l'hélium.

Le troisième mécanisme d'action des gaz rares correspond à la gravure sélective. Conformément à ce mécanisme, des atomes ou des radicaux du plasma peuvent réagir et se recombiner avec des espèces présentes à la surface de la pièce ; à titre d'exemple, l'azote ou l'hydrogène atomique du plasma peuvent se recombiner avec des atomes d'hydrogène présents à la surface de la pièce pour libérer H₂ ou NH, ce d'autant plus que le bore se trouve au voisinage des liaisons hydrogénées à la surface et qu'il agit comme catalyseur de la recombinaison et de la restitution de l'hydrogène.

Un autre paramètre essentiel du procédé conforme à l'invention est lié à l'injection d'azote dans le gaz précurseur ; on a en effet pu constater qu'il est impératif d'injecter une quantité suffisante d'azote pour obtenir des liaisons C-Nₓ en quantités relativement importantes et favoriser l'obtention d'une structure tétraédrique (alors même que le produit final peut en fait ne comporter que peu d'azote (quelques pour-cent incorporés)) mais qu'inversement l'ajout dans le gaz précurseur d'une quantité trop importante d'azote (de l'ordre de 70 à 90 %) a pour effet de désagréger la couche obtenue et d'entraîner des désordres chimiques suite au fait que l'azote non dissocié ne se lie pas en totalité aux atomes de carbone et reste à l'état libre dans le matériau.

Plus précisément, dans un plasma dans lequel on injecte de l'azote, on observe la présence, outre l'azote moléculaire, de radicaux N⁺, N₂⁺ et N, ces derniers pouvant, par gravure sélective, réagir avec des atomes d'hydrogène présents à la surface du substrat, de sorte que l'on a intérêt à avoir dans le plasma un maximum d'azote atomique. Cependant, la présence d'azote n'est parallèlement pas dénuée d'inconvénients vu qu'elle entraîne la formulation de particules N₂⁺ qui interviennent à la surface de la pièce pour y créer des « pseudo-molécules » instables de type -N=N- peu liées dans un environnement de carbone et qui ont tendance à se libérer sous l'effet d'une élévation de la température en entraînant une graphitisation. Il est donc essentiel pour obtenir un matériau suffisamment stable d'éviter au maximum la création de telles pseudo-molécules et de favoriser la formation de liaisons C-Nₓ solidement liées, ce qui, par suite de l'incorporation d'atomes d'azote dans la structure, entraîne une stabilisation des liaisons tétraédriques de type diamant.

On peut schématiquement parvenir à ce but de deux manières, à savoir soit en favorisant la dissociation du plasma de sorte qu'il comporte un maximum d'espèces atomiques simples au détriment des ions N₂⁺, soit en favorisant la gravure sélective des pseudo-molécules formées à partir de ces ions par l'hydrogène atomique de façon à entraîner la destruction de la double liaison (très faible) de celles-ci aboutissant ainsi à la restitution de NH.

Cette situation est largement de nature à prouver l'importance de la présence dans le plasma à la fois d'hydrogène et d'azote fortement dissociés, ce en présence de bore et donc de l'addition au gaz précurseur de gaz rares de nature à permettre une telle dissociation. Cet effet peut s'ajouter à la dissociation des espèces présentes dans le plasma provoquée par l'injection d'une plus grande puissance électrique en particulier par l'utilisation d'une source additionnelle de plasma réalisée par décharge RF, DC ou micro-onde mais qui peut nuire à la stabilité et aux conditions électriques de la décharge.

Le choix de la quantité de bore ajoutée est également essentiel vu qu'une quantité trop faible ne permet pas d'obtenir la détente des couches recherchée alors qu'une quantité trop importante entraîne une graphitisation du matériau qui devient par suite inutilisable.

Un autre paramètre essentiel du procédé qui fait l'objet de l'invention correspond au choix de l'énergie apportée à chaque atome de carbone du gaz précurseur. Il est, en effet, indispensable de se placer dans les conditions dites de « Lifschitz » qui définissent la plage d'énergie pour laquelle on obtient un maximum de structures tétraédriques de type diamant. En dehors de cette plage optimale, c'est-à-dire en cas de bombardement trop faible ou trop important, on obtient en effet une structure graphitique.

Cette plage optimale dépend bien entendu du gaz hydrocarboné mis en oeuvre et est à titre d'exemple plus élevée dans le cas du benzène que dans le cas du méthane ; on a, cependant, pu établir, selon une autre caractéristique de l'invention, qu'il convient d'apporter à chaque atome de carbone du gaz précurseur une énergie comprise entre 100 et 150 eV.

La mise en oeuvre du procédé susmentionné conforme à l'invention a permis l'obtention de pièces notamment de pièces métalliques revêtues d'une couche de carbone amorphe nitruré non hydrogéné se distinguant essentiellement par sa forte teneur en sites tétraédriques non hydrogénés (de plus de 40 %) et par sa grande dureté (6 000 à 8 000 HV).

Le diamant pur dispose de 100 % de sites tétraédriques non hydrogénés et sa dureté est de 10 000 HV ; les revêtements de diamant polycristallin ont quant à eux une dureté de l'ordre de 7 000 à 8 000 HV.

Le revêtement obtenu conformément à l'invention est donc plus dur que les carbones amorphes hydrogénés, plus stable thermiquement que ces mêmes dépôts et également plus stable chimiquement par suite de la stabilisation des sites tétraédriques par l'azote ; il est en outre amorphe et son coefficient de glissement est faible et indépendant de la teneur en humidité.

Une pièce ainsi revêtue peut, à titre d'exemple, correspondre à des outils de coupe, de découpe et de formage, à des pièces de moteurs et de systèmes hydrauliques et mécaniques, à des pièces d'usure dans des mécanismes, à des prothèses médicales...

Conformément à l'invention, on a également pu obtenir des revêtements protecteurs de grande dureté à base de titane, d'azote et de carbone en mettant en oeuvre un proçédé largement dérivé du procédé susmentionné d'obtention par la technique PECVD de revêtements de type pseudo carbone diamant amorphe à base de carbone et d'azote et essentiellement exempts d'hydrogène.

Il est à noter que des revêtements de type TiN, dans lesquels l'azote se trouve très fortement lié au titane sont actuellement largement employés dans des nombreuses branches de l'industrie ; ils peuvent avoir des duretés pouvant aller jusqu'à 3 500-4 000 HV dans la pratique mais ne sont cependant que rarement utilisés au delà de 3 000 HV compte tenu de l'importance des contraintes internes. Or, il est connu que la dureté de ces revêtements est fonction de l'ionisation du plasma (plus on ionise le plasma, plus on y injecte de puissance) ; cependant, en corollaire, plus cette dureté augmente, plus les contraintes sont importantes vu que de nombreux éléments peuvent se glisser en position interstitielle.

De tels revêtements qui sont thermiquement stables jusqu'à environ 700°C et se dégradent au-delà sont classiquement fabriqués par la technique PECVD en mettant en oeuvre un gaz précurseur contenant du titane et de l'azote.

Lors de la mise en oeuvre de ce procédé, on se heurte cependant aux inconvénients susmentionnés, liés à la nécessité, pour obtenir un revêtement TiN de texture satisfaisante de disposer d'un maximum d'azote atomique, donc de dissocier très fortement l'azote introduit dans le gaz précurseur et parallèlement de permettre une élimination par gravure sélective des groupements pseudo-moléculaires -N=N- pouvant être présents à la surface de la pièce par des atomes d'hydrogène dissociés.

La présente invention permet également de remédier à cet inconvénient en proposant un procédé de dépôt sur au moins une pièce d'un revêtement protecteur de grande dureté essentiellement exempt d'hydrogène, à base de titane, d'azote et de carbone par la technique PECVD.

Conformément à ce procédé, on introduit un gaz précurseur renfermant les éléments à déposer ainsi que des agents dopants dans une chambre à vide renfermant un support métallique relié à un générateur puissant de courant continu ou alternatif travaillant dans le domaine des radiofréquences ou des micro-ondes et sur lequel se trouve la pièce à revêtir et on entretient une décharge électrique à l'intérieur de la chambre dans des conditions de température, de puissance et de pression permettant l'excitation physique et chimique du gaz précurseur et son ionisation sous forme de plasma de façon à provoquer le dépôt, par bombardement ionique sur la pièce, d'un revêtement protecteur de grande dureté de type TiCN.

Selon l'invention, ce procédé est caractérisé en ce que le gaz précurseur contient de l'azote, du titane ainsi que 10 à 70 % d'hydrogène associé à un ou plusieurs hydrocarbures et entre 0,5 et 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN, on ajoute à ce gaz précurseur entre 10 et 70 % d'un mélange d'hélium et d'argon ou entre 10 et 70 % de néon dont le rôle est d'exciter fortement et de dissocier simultanément l'azote et l'hydrogène, et on choisit l'énergie apportée à chaque atome du gaz précurseur de façon à se placer dans des conditions qui définissent la plage d'énergie pour laquelle on obtient un maximum de structures tétraédriques de type diamant aux dépens de structures hexagonales de type graphitique.

On peut ainsi obtenir des revêtements de type TiN-CN-TiC dits « TiCN » (en réalité TiₓC_{y}N_{z}).

Pour que ces revêtements aient une dureté satisfaisante, il est nécessaire de veiller à ce que l'azote soit liée au titane et également au carbone de façon à obtenir un conglomérat unique lié en un seul réseau.

Il est à noter que le bore mis en oeuvre dans ce procédé se retrouve à l'état de quelques pour-cent dans le dépôt, ce sans affecter de manière significative la structure de celui-ci.

Conformément à l'invention, les principes de base susmentionnés peuvent également s'adapter à l'obtention de revêtements protecteurs de grande dureté à base de bore et d'azote de type BN par la mise en oeuvre de la technique PECVD.

En conséquence, l'invention se rapporte également à un procédé permettant le dépôt sur au moins une pièce d'un revêtement protecteur de grande dureté essentiellement exempt d'hydrogène, de structure à dominante tétraédrique, à base de bore et d'azote, par la technique PECVD.

Il est en effet connu que le nitrure de bore peut se présenter tout comme le carbone sous la forme de deux phases : une phase cubique (comparable au diamant) et une phase hexagonale (comparable au graphique).

Le nitrure de bore cubique est un dépôt très dur de l'ordre de 6 000 HV qui, quoique moins dur que les dépôts de type CNₓ, est beaucoup plus dur que le carbone amorphe hydrogéné et a l'avantage d'être beaucoup plus stable thermiquement (plus de 1 200°C). De ce fait, de tels dépôts commencent également à être utilisés, à côté des dépôts susmentionnés, pour les applications mécaniques mais également pour l'optoélectronique, car ces matériaux disposent d'un « gap » électronique important de l'ordre de 5 à 7 eV.

De plus, des résultats de recherche ont montré que la croissance de ces dépôts, à partir de sources d'azote et de bore, fait apparaître la structure cubique lorsque l'énergie du bombardement ionique est égale à 400 à 500 eV et la température supérieure à 350°C. On est donc en présence d'un mécanisme pouvant être assimilé à celui des conditions de « Lifschitz » pour le carbone.

En conséquence, on a eu l'idée, conformément à l'invention, de favoriser la croissance d'une phase cubique pure grâce à la mise en oeuvre de moyens essentiellement similaires à deux utilisés pour les revêtements à base de carbone et d'azote, c'est-à-dire en augmentant la proportion d'azote atomique dans le plasma, donc en favorisant la dissociation de l'azote introduit dans le gaz précurseur ou dans le gaz de pulvérisation de façon à disposer d'un maximum d'azote atomique et en permettant l'élimination par gravure sélective des composés pseudo-moléculaires de type -N=N- pouvant être présents à la surface de la pièce à revêtir à l'aide d'hydrogène dissocié.

Lors de la mise en oeuvre de cette technique, on introduit un gaz précurseur renfermant les éléments à déposer ainsi que des agents dopants dans une chambre à vide renfermant un support métallique relié à un générateur puissant de courant continu ou alternatif travaillant dans le domaine des radiofréquences ou des micro-ondes et sur lequel se trouve la pièce à revêtir et on entretient une décharge électrique à l'intérieur de la chambre dans des conditions de température, de puissance et de pression permettant l'excitation physique et chimique du gaz précurseur et son ionisation sous forme de plasma de façon à provoquer le dépôt par bombardement ionique, sur la pièce d'un revêtement protecteur de grande dureté de type BN.

Selon l'invention, ce procédé est caractérisé en ce que le gaz précurseur contient 10 à 70 % d'hydrogène ainsi que du bore, notamment du diborane ou encore du chlorure de bore ou du triméthylbore et de l'ammoniac ainsi que de l'azote, on ajoute à ce gaz précurseur entre 10 et 70 % d'un mélange d'hélium et d'argon ou entre 10 et 70 % de néon dont le rôle est d'exciter fortement et de dissocier simultanément l'azote et l'hydrogène, et on choisit l'énergie apportée à chaque ion du plasma réalisé à partir du gaz précurseur de façon à se placer dans des conditions qui définissent la plage d'énergie pour laquelle on obtient un maximum de structures tétraédriques de type diamant aux dépens de structures hexagonales.

Il est à noter que, dans le cas où, en tant que gaz précurseur, on utilise le chlorure de bore, le triméthylbore et l'ammoniac, l'hydrogène atomique élimine le chlore, le carbone et l'hydrogène surabondants.

Toutefois, en dosant la dissociation de l'hydrogène, on peut conserver une fraction de carbone qui sert à doper le matériau déposé et à réduire son « gap » électronique.

Par ailleurs, on a pu établir que pour respecter les pseudo conditions de « Lifschitz », il faut travailler à moins de 5 Pa de pression totale.

De plus, la somme des gaz rares mis en oeuvre ne doit pas dépasser 30 % du mélange gazeux total, faute de quoi la pulvérisation par le bombardement ionique de ces gaz devient trop importante et limite sévèrement la vitesse du dépôt.

Parallèlement, la pression partielle d'hydrogène ne doit pas dépasser 70 %, faute de quoi on ne disposer plus d'assez de gaz précurseur pour assurer la croissance du dépôt.

Conformément à une variante de l'invention, on a pu obtenir des pièces revêtues de couches largement similaires en utilisant, non pas la technique PECVD, mais la technique PVD (Physical Vapour Deposition) assisté ou non de champ magnétique (technique dite « magnétron » avec champ magnétique ou « pulvérisation diode » sans champ magnétique).

L'invention se rapporte donc également à un procédé de dépôt sur au moins une pièce d'un revêtement protecteur de type pseudo carbone diamant amorphe à base de carbone et d'azote et essentiellement exempt d'hydrogène par la technique PVD assisté ou non de champ magnétique.

Conformément à ce procédé, on introduit un gaz de pulvérisation renfermant des éléments à déposer dans une chambre à vide renfermant un support métallique relié à un générateur puissant de courant continu ou alternatif travaillant dans le domaine des radiofréquences ou des micro-ondes et sur lequel se trouve la pièce à revêtir en créant une décharge de façon à permettre l'excitation physique et chimique du gaz de pulvérisation et son ionisation sous forme de plasma, et on pulvérise en surface une cible réalisée en un matériau ou un alliage renfermant également des éléments à déposer, située dans la chambre à vide et alimentée en courant continu ou radiofréquence de façon à provoquer le dépôt sur la pièce d'un revêtement protecteur de grande dureté de type pseudo carbone diamant amorphe.

Un tel procédé se distingue donc de la technique PECVD en ce que, au lieu d'introduire dans l'enceinte un gaz précurseur hydrocarboné, on y introduit une cible solide, généralement en graphite ; les espèce qui se déposent sur la pièce par bombardement ionique ne sont donc pas obtenues de façon chimique comme dans la technique PECVD mais de façon physique par suite de la pulvérisation d'une cible solide.

Il est à noter que des chercheurs ont déjà tenté d'obtenir par la mise en oeuvre d'un tel procédé la formation de liaison C-Nₓ à la surface d'une pièce. On a, à titre d'exemple, déjà proposé d'introduire de l'argon dans un plasma d'azote ; l'argon peut ainsi dissocier un peu l'azote de manière à obtenir des atomes N susceptibles de se lier avec le carbone pulvérisé pour créer des liaisons C-Nₓ. La structure du revêtement ainsi obtenu n'est cependant pas idéale car une proportion importante de l'azote n'est pas dissociée mais transformée en particules N₂⁺, entraînant la formation à la surface de la pièce de pseudo-molécules instables -N=N- du type susmentionné avec les inconvénients qui en résultent.

Le procédé conforme à l'invention permet de remédier à ces inconvénients.

Celui-ci est caractérisé en ce qu'on pulvérise une cible en graphite, le gaz de pulvérisation de cette cible renferme entre 5 et 40 % d'azote et entre 5 et 40 % d'hydrogène ainsi qu'entre 0,5 et 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN, on ajoute à ce gaz de pulvérisation entre 10 et 70 % d'un mélange d'hélium et d'argon ou entre 10 et 70 % de néon dont le rôle est d'exciter fortement et de dissocier simultanément l'azote et l'hydrogène, et on choisit les caractéristiques du courant alimentant le support portant la pièce de façon à obtenir une polarisation radiofréquence de ce support permettant de se placer dans des conditions qui définissent la plage d'énergie pour laquelle on obtient un maximum de structures tétraédriques de type diamant aux dépens de structures hexagonales de type graphitique.

En conséquence, les caractéristiques et remarques susmentionnées relatives au procédé conforme à l'invention permettant de déposer sur une pièce un revêtement protecteur de type pseudo carbone diamant amorphe à la fois dur, stable thermique et adhérant par la technique PECVD, peuvent parfaitement s'adapter à un procédé d'obtention d'un revêtement largement similaire par la technique PVD à la condition d'ajouter des traces de bore et de l'hydrogène dans le plasma ; cet hydrogène peut ensuite être fortement dissocié de façon à graver sélectivement les pseudo-molécules -N=N- pouvant être présentes à la surface de la pièce. Bien entendu, il est alors essentiel d'utiliser une polarisation radiofréquence du support portant la pièce de façon à réaliser les conditions de « Lifschitz ».

La technique PVD est en fait plus onéreuse que la technique PECVD et exige la mise en oeuvre d'un appareillage plus sophistiqué ; elle peut néanmoins trouver des domaines d'applications tels qu'à titre d'exemple le revêtement de l'intérieur de tubes ou de disques magnétiques ou encore la fabrication d'écrans plats.

Conformément à l'invention, des revêtements protecteurs de grande dureté de type TiCN largement similaire aux revêtements susmentionnés peuvent également être obtenus par la mise en oeuvre d'un procédé dérivé de la technique PVD en choisissant un gaz de pulvérisation renfermant de l'azote, des gaz rares et le cas échéant un ou plusieurs hydrocarbures et en pulvérisant une cible en titane ou en nitrure de titane située dans la chambre à vide.

L'invention se rapporte également à un tel procédé.

Conformément à ce procédé, on introduit un gaz de pulvérisation renfermant des éléments à déposer dans une chambre à vide renfermant un support métallique relié à un générateur puissant de courant continu ou alternatif travaillant dans le domaine des radiofréquences ou des micro-ondes et sur lequel se trouve la pièce à revêtir en créant une décharge de façon à permettre l'excitation physique et chimique du gaz de pulvérisation et son ionisation sous forme de plasma, et on pulvérise en surface une cible réalisée en un matériau ou un alliage renfermant également des éléments à déposer, située dans la chambre à vide et alimentée en courant continu ou radiofréquence de façon à provoquer le dépôt sur la pièce d'un revêtement protecteur de grande dureté de type TiCN.

Selon l'invention, ce procédé est caractérisé en ce qu'on pulvérise une cible en titane ou en nitrure de titane, le gaz de pulvérisation de cette cible contient de l'azote, ainsi que 10 à 70 % d'hydrogène associé à un ou plusieurs hydrocarbures et 0,5 à 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN, on ajoute à ce gaz de pulvérisation entre 10 et 70 % d'un mélange d'hélium et d'argon ou entre 10 et 70 % de néon dont le rôle est d'exciter fortement et de dissocier simultanément l'azote et l'hydrogène, et on choisit les caractéristiques du courant alimentant le support portant la pièce de façon à obtenir une polarisation radiofréquence de ce support permettant de se placer dans des conditions qui définissent la plage d'énergie pour laquelle on obtient un maximum de structures tétraédriques de type diamant aux dépens de structures hexagonales de type graphitique.

Il est à noter que conformément à l'invention, le bore peut se trouver sous forme de B₂H₆ de B(CH₃)₃ ou d'autres composés nitro et/ou carbo et/ou hydro borés.

En conclusion, l'invention permet d'améliorer la texture des revêtements classiques de type TiCN, ce qu'ils soient obtenus par la technique PECVD ou par la technique PVD grâce à une augmentation de la dissociation de l'azote dans le plasma et à la possibilité d'éliminer les pseudo-molécules -N=N- pouvant être présentes à la surface de la pièce par gravure sélective par l'hydrogène atomique.

Il est à noter que pour tous les produits à base de titane et d'azote, le choix de l'énergie optimale du bombardement ionique dépend de la teneur en azote : en présente d'un excès d'azote par rapport à la stoechiométrie, une trop forte énergie provoque une augmentation trop importante de l'azote interstitiel et par suite nuit à l'adhérence des dépôts ; au contraire, en présence d'un défaut stoechiométrique d'azote, l'augmentation de l'énergie permet de combler les lacunes d'où il résulte une meilleure cohésion et dureté du matériau sans augmentation intempestive des contraintes.

Cette situation explique l'intérêt d'augmenter l'ionisation et la dissociation de l'azote grâce à la présence d'hélium ou de néon.

Cette ionisation et cette dissociation de l'azote viennent, bien entendu, s'ajouter à celle consécutive à l'injection d'une plus grande puissance électrique en particulier par l'utilisation d'une source additionnelle de plasma réalisée par décharge RF, DC ou micro-onde à la condition que la stabilité de la décharge ne soit pas affectée et que les conditions du bombardement ionique soient respectées.

Conformément à l'invention, des revêtements protecteurs de grande dureté à base de bore et d'azote, largement similaires aux revêtements susmentionnés peuvent également être obtenus par la mise en oeuvre d'un procédé dérivé de la technique PVD, en introduisant dans la chambre à vide un gaz de pulvérisation ainsi qu'une cible de nitrure de bore massive.

Conformément à ce procédé, on introduit un gaz de pulvérisation renfermant des éléments à déposer dans une chambre à vide renfermant un support métallique relié à un générateur puissant de courant continu ou alternatif travaillant dans le domaine des radiofréquences ou des micro-ondes et sur lequel se trouve la pièce à revêtir en créant une décharge de façon à permettre l'excitation physique et chimique du gaz de pulvérisation et son ionisation sous forme de plasma et on pulvérise en surface une cible réalisée en un matériau ou un alliage renfermant également des éléments à déposer, située dans la chambre à vide et alimentée en courant continu ou radiofréquence de façon à provoquer le dépôt sur la pièce d'un revêtement protecteur de grande dureté de type BN.

Selon l'invention, ce procédé est caractérisé en ce qu'on pulvérise une cible en nitrure de bore massive, le gaz de pulvérisation de cette cible renferme entre 5 et 40 % d'azote et entre 5 et 40 % d'hydrogène, on ajoute à ce gaz de pulvérisation entre 10 et 70 % d'un mélange d'hélium et d'argon ou entre 10 et 70 % de néon dont le rôle est d'exciter fortement et de dissocier simultanément l'azote et l'hydrogène, et on choisit les caractéristiques du courant alimentant le support portant la pièce de façon à obtenir une polarisation radiofréquence de ce support permettant de se placer dans des conditions qui définissent la plage d'énergie pour laquelle on obtient un maximum de structures tétraédriques de type diamant aux dépens de structures hexagonales de type graphitique.

Lors de la mise en oeuvre de ce procédé, les gaz rares permettent de dissocier l'azote introduit pour compenser les pertes réalisées par la pulvérisation sélective de l'azote dans la cible solide et l'hydrogène qui est largement dissocié par le mélange azote/hydrogène d'une part et par les gaz rares d'autre part.

Il est par ailleurs bien connu des spécialistes de la physique des plasmas qu'un volume de plasma est toujours entouré d'une zone appelée « gaine » à travers laquelle les ions sont accélérés. Or, selon la composition du plasma, on peut se trouver en présence de gaines dites « gaines collisionnelles » dans lesquelles il se produit des réactions de collision dont la conséquence est l'apparition d'énergies très diverses dont certaines correspondent aux conditions de « Lifschitz » tandis que d'autres n'y correspondent pas, ce qui conduit à l'obtention d'un dépôt peu dur et hydrogéné.

Il est donc, par suite, essentiel selon une autre caractéristique de l'invention, de choisir les conditions de puissance et de pression régnant à l'intérieur de la chambre à vide de façon à créer un plasma à gaine non collisionnelle permettant de réduire la plage de l'énergie apportée à chacun des atomes de carbone du gaz précurseur.

Il est en outre à noter que, conformément à l'invention, on peut exciter le plasma par radiofréquence (13,56 MHz) ; on a toutefois intérêt à travailler en micro-ondes (2,45 GHz) donc à plus basse pression : on peut, en effet, en utilisant une « nappe d'antenne » ou une source micro-onde à fente de grande longueur, réaliser des réacteurs de grandes dimensions (plusieurs mètres carrés) et donc permettre la mise en oeuvre du procédé à grande échelle.

Selon une autre caractéristique de l'invention, il est possible de superposer de façon connue en elle-même une pulsation au courant fourni par le générateur de sorte que le plasma ne soit activé que pendant une fraction cyclique du temps de traitement.

En particulier, en activant le plasma pendant 10 à 80 % du temps de traitement, à une fréquence comprise entre 1 et 100 kHz, on a pu abaisser de façon déterminante la température des revêtements obtenus en permettant, d'une part, de travailler avec des puissances beaucoup plus importantes que celles classiquement mises en oeuvre et ce pour des puissances moyennes pratiquement identiques de 0,1 à 0,5 W/cm², et d'autre part de faire en sorte que les ions négatifs puissent quitter le plasma pour se déposer sur les surfaces à traiter, ce qui permet d'éviter l'apparition de poussières et d'améliorer la cohésion du dépôt, d'en diminuer les contraintes internes et par suite d'améliorer l'adhérence.

Il est à noter que l'addition d'une grande quantité d'hélium conduit à une dissociation poussée des liaisons CₓH_{y} et permet ainsi d'obtenir des dépôts de carbone amorphe non hydrogéné.

Cependant, lorsque l'on travaille à haute pression avec une pression partielle de CₓH_{y} suffisante pour obtenir une vitesse de dépôt intéressante les gaines sont collisionnelles et les conditions de « Lifschitz » ne peuvent pas être respectées d'où il résulte une graphitisation.

Dans le cas contraire, c'est-à-dire lorsque l'on travaille à basse pression la vitesse de dépôt devient insuffisante.

## Revendications

1. Procédé de dépôt sur au moins une pièce d'un revêtement protecteur de grande dureté essentiellement exempt d'hydrogène, de structure à dominante tétraédrique, à base de carbone et d'azote par la technique PECVD par laquelle on introduit un gaz précurseur renfermant les éléments à déposer ainsi que des agents dopants dans une chambre à vide renfermant un support métallique relié à un générateur puissant de courant continu ou alternatif travaillant dans le domaine des radiofréquences ou des micro-ondes et sur lequel se trouve la pièce à revêtir et on entretient une décharge électrique à l'intérieur de la chambre de façon à élever la température de la pièce à une valeur de 150 ) 400°C lorsque l'épaisseur du dépôt dépasse 1 *µ*, et dans des conditions de température, de puissance et de pression permettant l'excitation physique et chimique du gaz précurseur et son ionisation sous forme de plasma de façon à provoquer le dépôt, par bombardement ionique sur la pièce d'un revêtement protecteur de grande dureté de type pseudo carbone diamant amorphe,
procédé caractérisé en ce que
le gaz précurseur contient entre 10 et 70 % d'azote associé à un ou plusieurs hydrocarbures ainsi que 0,5 à 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN,
on ajoute à ce gaz précurseur entre 10 et 70 % d'un mélange d'hélium et d'argon ou entre 10 et 70 % de néon dont le rôle est d'exciter fortement et de dissocier simultanément l'azote et l'hydrogène, et
on choisit l'énergie apportée à chaque atome du gaz précurseur de façon à se placer dans des conditions qui définissent la plage d'énergie pour laquelle on obtient un maximum de structures tétraédriques de type diamant aux dépens de structures hexagonales de type graphitique.

2. Procédé selon la revendication 1,
caractérisé en ce qu'
on apporte à chaque atome de carbone du gaz précurseur une énergie comprise entre 100 et 150 eV.

3. Procédé de dépôt sur au moins une pièce d'un revêtement protecteur de grande dureté essentiellement exempt d'hydrogène, à base de titane, d'azote et de carbone par la technique PECVD par laquelle on introduit un gaz précurseur renfermant les éléments à déposer ainsi que des agents dopants dans une chambre à vide renfermant un support métallique relié à un générateur puissant de courant continu ou alternatif travaillant dans le domaine des radiofréquences ou des micro-ondes et sur lequel se trouve la pièce à revêtir et on entretient une décharge électrique à l'intérieur de la chambre dans des conditions de température, de puissance et de pression permettant l'excitation physique et chimique du gaz précurseur et son ionisation sous forme de plasma de façon à provoquer le dépôt d'un revêtement protecteur de grande dureté de type TiCN,
procédé caractérisé en ce que
le gaz précurseur contient de l'azote, du titane ainsi que 10 à 70 % d'hydrogène associé à un ou plusieurs hydrocarbures et entre 0,5 et 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN,
on ajoute à ce gaz précurseur entre 10 et 70 % d'un mélange d'hélium et d'argon ou entre 10 et 70 % de néon dont le rôle est d'exciter fortement et de dissocier simultanément l'azote et l'hydrogène, et
on choisit l'énergie apportée à chaque atome du gaz précurseur de façon à se placer dans des conditions qui définissent la plage d'énergie pour laquelle on obtient un maximum de structures tétraédriques de type diamant aux dépens de structures hexagonales de type graphitique.

4. Procédé de dépôt sur au moins une pièce d'un revêtement protecteur de grande dureté essentiellement exempt d'hydrogène, de structure à dominante tétraédrique, à base de bore et d'azote, par la technique PECVD par laquelle on introduit un gaz précurseur renfermant les éléments à déposer ainsi que des agents dopants dans une chambre à vide renfermant un support métallique relié à un générateur puissant de courant continu ou alternatif travaillant dans le domaine des radiofréquences ou des micro-ondes et sur lequel se trouve la pièce à revêtir et on entretient une décharge électrique à l'intérieur de la chambre dans des conditions de température, de puissance et de pression permettant l'excitation physique et chimique du gaz précurseur et son ionisation sous forme de plasma de façon à provoquer le dépôt par bombardement ionique, sur la pièce d'un revêtement protecteur de grande dureté de type BN,
procédé caractérisé en ce que
le gaz précurseur contient 10 à 70 % d'hydrogène ainsi que du bore, notamment du diborane ou encore du chlorure de bore, du triméthylbore et de l'ammoniac ainsi que de l'azote,
on ajoute à ce gaz précurseur entre 10 et 70 % d'un mélange d'hélium et d'argon ou entre 10 et 70 % de néon dont le rôle est d'exciter fortement et de dissocier simultanément l'azote et l'hydrogène, et
on choisit l'énergie apportée à chaque ion du plasma réalisé à partir du gaz précurseur de façon à se placer dans des conditions qui définissent la plage d'énergie pour laquelle on obtient un maximum de structures tétraédriques de type diamant aux dépens de structures hexagonales.

5. Procédé de dépôt, sur au moins une pièce d'un revêtement protecteur de grande dureté essentiellement exempt d'hydrogène, de structure à dominante tétraédrique, à base de carbone et d'azote par la technique PVD assisté ou non de champ magnétique, par laquelle on introduit un gaz de pulvérisation renfermant des éléments à déposer dans une chambre à vide renfermant un support métallique relié à un générateur puissant de courant continu ou alternatif travaillant dans le domaine des radiofréquences ou des micro-ondes et sur lequel se trouve la pièce à revêtir en créant une décharge de façon à permettre l'excitation physique et chimique du gaz de pulvérisation et son ionisation sous forme de plasma, et on pulvérise en surface une cible réalisée en un matériau ou un alliage renfermant également des éléments à déposer, située dans la chambre à vide et alimentée en courant continu ou radiofréquence de façon à provoquer le dépôt sur la pièce d'un revêtement protecteur de grande dureté de type pseudo carbone diamant amorphe,
procédé caractérisé en ce qu'
on pulvérise une cible en graphite,
le gaz de pulvérisation de cette cible renferme entre 5 et 40 % d'azote et entre 5 et 40 % d'hydrogène ainsi qu'entre 0,5 et 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN,
on ajoute à ce gaz de pulvérisation entre 10 et 70 % d'un mélange d'hélium et d'argon ou entre 10 et 70 % de néon dont le rôle est d'exciter fortement et de dissocier simultanément l'azote et l'hydrogène, et
on choisit les caractéristiques du courant alimentant le support portant la pièce de façon à obtenir une polarisation radiofréquence de ce support permettant de se placer dans des conditions qui définissent la plage d'énergie pour laquelle on obtient un maximum de structures tétraédriques de type diamant aux dépens de structures hexagonales de type graphitique.

6. Procédé de dépôt sur au moins une pièce d'un revêtement protecteur de grande dureté, à base de titane, d'azote et de carbone par la technique PVD assisté ou non de champ magnétique, par laquelle on introduit un gaz de pulvérisation renfermant des éléments à déposer dans une chambre à vide renfermant un support métallique relié à un générateur puissant de courant continu ou alternatif travaillant dans le domaine des radiofréquences ou des micro-ondes et sur lequel se trouve la pièce à revêtir en créant une décharge de façon à permettre l'excitation physique et chimique du gaz de pulvérisation et son ionisation sous forme de plasma, et on pulvérise en surface une cible réalisée en un matériau ou un alliage renfermant également des éléments à déposer, située dans la chambre à vide et alimentée en courant continu ou radiofréquence de façon à provoquer le dépôt sur la pièce d'un revêtement protecteur de grande dureté de type TiCN,
procédé caractérisé en ce que
on pulvérise une cible en titane ou en nitrure de titane,
le gaz de pulvérisation de cette cible contient de l'azote, ainsi que 10 à 70 % d'hydrogène associé à un ou plusieurs hydrocarbures et 0,5 à 5 % de bore agissant en tant que catalyseur pour détendre les liaisons de type CH de façon à permettre d'éliminer l'hydrogène par recombinaison avec l'hydrogène atomique et l'azote atomique et à faciliter l'obtention de liaisons CN,
on ajoute à ce gaz de pulvérisation entre 10 et 70 % d'un mélange d'hélium et d'argon ou entre 10 et 70 % de néon dont le rôle est d'exciter fortement et de dissocier simultanément l'azote et l'hydrogène, et
on choisit les caractéristiques du courant alimentant le support portant la pièce de façon à obtenir une polarisation radiofréquence de ce support permettant de se placer dans des conditions qui définissent la plage d'énergie pour laquelle on obtient un maximum de structures tétraédriques de type diamant aux dépens de structures hexagonales de type graphitique.

7. Procédé de dépôt sur au moins une pièce d'un revêtement protecteur de grande dureté, de structure à dominante tétraédrique, à base de bore et d'azote, par la technique PVD assisté ou non de champ magnétique, par laquelle on introduit un gaz de pulvérisation renfermant des éléments à déposer dans une chambre à vide renfermant un support métallique relié à un générateur puissant de courant continu ou alternatif travaillant dans le domaine des radiofréquences ou des micro-ondes et sur lequel se trouve la pièce à revêtir en créant une décharge de façon à permettre l'excitation physique et chimique du gaz de pulvérisation et son ionisation sous forme de plasma et on pulvérise en surface une ciblé réalisée en un matériau ou un alliage renfermant également des éléments à déposer, située dans la chambre à vide et alimentée en courant continu ou radiofréquence de façon à provoquer le dépôt sur la pièce d'un revêtement protecteur de grande dureté de type BN,
procédé caractérisé en ce que
on pulvérise une cible en nitrure de bore massive,
le gaz de pulvérisation de cette cible renferme entre 5 et 40 % d'azote et entre 5 et 40 % d'hydrogène,
on ajoute à ce gaz de pulvérisation entre 10 et 70 % d'un mélange d'hélium et d'argon ou entre 10 et 70 % de néon dont le rôle est d'exciter fortement et de dissocier simultanément l'azote et l'hydrogène, et
on choisit les caractéristiques du courant alimentant le support portant la pièce de façon à obtenir une polarisation radiofréquence de ce support permettant de se placer dans des conditions qui définissent la plage d'énergie pour laquelle on obtient un maximum de structures tétraédriques de type diamant aux dépens de structures hexagonales de type graphitique.

8. Procédé selon l'une quelconque des revendications 1 à 7,
caractérisé en ce que
l'on choisit les conditions de puissance et de pression régnant à l'intérieur de la chambre à vide de façon à créer un plasma à gaine non collisionnelle permettant d'uniformiser l'énergie apportée à chacun des atomes du gaz précurseur ou du gaz de pulvérisation et du matériau pulvérisé.

9. Procédé selon l'une quelconque des revendications 1 à 8,
caractérisé en ce que
l'on met en oeuvre un générateur travaillant dans le domaine des micro-ondes.

10. Procédé selon l'une quelconque des revendications 1 à 9,
caractérisé en ce que
l'on superpose une pulsation au courant fourni par le générateur de sorte que le plasma ne soit activé que pendant une fraction cyclique du temps de traitement.

## Patentansprüche

1. Verfahren zur Herstellung einer Schutzschicht von großer Härte, auf zumindest einem Werkstück, im wesentlichen frei von Wasserstoff, mit überwiegend tetraederförmiger Struktur auf der Basis von Kohlenstoff und Stickstoff nach der plasmagestützten CVD-Technik, bei der ein die zu beschichtenden Elemente umgebendes Vorläufergas sowie Dotierstoffe in eine Vakuumkammer eingeführt werden, die eine an einen im Hochfrequenz- oder Mikrowellenbereich arbeitenden Gleich- oder Wechselstrom-Großgenerator angeschlossene metallische Auflage umschließt, auf der sich das zu beschichtende Werkstück befindet, und im Inneren der Kammer eine elektrische Entladung aufrechterhalten wird, um die Temperatur des Werkstücks auf einen Wert von 150 bis 400°C bei einem Überschreiten der Dicke der Schicht von 1 *µ* zu erhöhen, und unter Bedingungen der Temperatur, der Stärke und des Druckes, die eine physische und chemische Anregung des Vorläufergases und dessen Ionisierung in Plasmaform ermöglichen, um durch Ionenbeschuß auf dem Werkstück die Herstellung einer Schutzschicht von großer Härte von der Art eines amorphen Pseudokohlenstoffdiamanten herbeizuführen, wobei das Verfahren dadurch gekennzeichnet ist, daß das Vorläufergas 10 bis 70 % Stickstoff, gebunden an einen oder mehrere Kohlenwasserstoffe, sowie 0,5 bis 5 % Bor enthält, das als Katalysator wirkt, um die Verbindungen vom CH-Typ zu entspannen, damit der Wasserstoff durch Rekombination mit dem atomaren Wasserstoff und dem atomaren Stickstoff eliminiert werden kann und um die Gewinnung von CN-Verbindungen zu fördern, dem Vorläufergas 10 bis 70 % eines Gemisches von Helium und Argon oder 10 bis 70 % Neon zugesetzt wird, dessen Funktion darin besteht, den Stickstoff und den Wasserstoff stark anzuregen und gleichzeitig zu dissoziieren, und die jedem Atom des Vorläufergases zugeführte Energie derart gewählt wird, daß sie Bedingungen einhält, die den Energiebereich definieren, für den ein Maximum an tetraederförmigen Strukturen des Diamanttyps auf Kosten hexagonaler Strukturen des Graphittyps erreicht wird.

2. Verfahren nach Anspruch 1, dadurch gekennzeichnet, daß jedem Kohlenstoffatom des Vorläufergases Energie im Bereich von 100 bis 150 eV zugeführt wird.

3. Verfahren zur Herstellung einer Schutzschicht von großer Härte, auf zumindest einem Werkstück, im wesentlichen frei von Wasserstoff, auf der Basis von Titan, Stickstoff und Kohlenstoff nach der plasmagestützten CVD-Technik, bei der ein die zu beschichtenden Elemente umgebendes Vorläufergas sowie Dotierstoffe in eine Vakuumkammer eingeführt werden, die eine an einen im Hochfrequenz- oder Mikrowellenbereich arbeitenden Gleich- oder Wechselstrom-Großgenerator angeschlossene metallische Auflage umschließt, auf der sich das zu beschichtende Werkstück befindet, und im Inneren der Kammer eine elektrische Entladung unter Bedingungen der Temperatur, der Stärke und des Druckes aufrechterhalten wird, die eine physische und chemische Anregung des Vorläufergases und dessen Ionisierung in Plasmaform ermöglichen, um die Herstellung einer Schutzschicht von großer Härte vom TiCN-Typ herbeizuführen, wobei das Verfahren dadurch gekennzeichnet ist, daß das Vorläufergas Stickstoff, Titan sowie 10 bis 70 % Wasserstoff, gebunden an einen oder mehrere Kohlenwasserstoffe, und 0,5 bis 5 % Bor enthält, das als Katalysator wirkt, um die Verbindungen vom CH-Typ zu entspannen, damit der Wasserstoff durch Rekombination mit dem atomaren Wasserstoff und dem atomaren Stickstoff eliminiert werden kann und um die Gewinnung von CN-Verbindungen zu fördern, dem Vorläufergas 10 bis 70 % eines Gemisches von Helium und Argon oder 10 bis 70 % Neon zugesetzt wird, dessen Funktion darin besteht, den Stickstoff und den Wasserstoff stark anzuregen und gleichzeitig zu dissoziieren, und die jedem Atom des Vorläufergases zugeführte Energie derart gewählt wird, daß sie Bedingungen einhält, die den Energiebedarf definieren, für den ein Maximum an tetraederförmigen Strukturen des Diamanttyps auf Kosten hexagonaler Strukturen des Graphittyps erreicht wird.

4. Verfahren zur Herstellung einer Schutzschicht von großer Härte, auf zumindest einem Werkstück, im wesentlichen frei von Wasserstoff, mit überwiegend tetraederförmiger Struktur auf der Basis von Bor und Stickstoff nach der plasmagestützten CVD-Technik, bei der ein die zu beschichtenden Elemente umgebendes Vorläufergas sowie Dotierstoffe in eine Vakuumkammer eingeführt werden, die eine an einen im Hochfrequenz- oder Mikrowellenbereich arbeitenden Gleich- oder Wechselstrom-Großgenerator angeschlossene metallische Auflage umschließt, auf der sich das zu beschichtende Werkstück befindet, und im Inneren der Kammer eine elektrische Entladung unter Bedingungen der Temperatur, der Stärke und des Druckes aufrechterhalten wird, die eine physische und chemische Anregung des Vorläufergases und dessen Ionisierung in Plasmaform ermöglichen, um durch Ionenbeschuß auf dem Werkstück die Herstellung einer Schutzschicht von großer Härte des BN-Typs herbeizuführen, wobei das Verfahren dadurch gekennzeichnet ist, daß das Vorläufergas 10 bis 70 % Wasserstoff sowie Bor, insbesondere Diboran oder auch Borchlorid, Trimethylbor und Ammoniak sowie Stickstoff enthält, dem Vorläufergas 10 bis 70 % eines Gemisches von Helium und Argon oder 10 bis 70 % Neon zugesetzt wird, dessen Funktion darin besteht, den Stickstoff und den Wasserstoff stark anzuregen und gleichzeitig zu dissoziieren, und die jedem Ion des ausgehend von dem Vorläufergas erzeugten Plasmas zugeführte Energie derart gewählt wird, daß sie Bedingungen einhält, die den Energiebereich definieren, für den ein Maximum an tetraederförmigen Strukturen des Diamanttyps auf Kosten hexagonaler Strukturen erreicht wird.

5. Verfahren zur Herstellung einer Schutzschicht von großer Härte, auf zumindest einem Werkstück, im wesentlichen frei von Wasserstoff, mit überwiegend tetraederförmiger Struktur auf der Basis von Kohlenstoff und Stickstoff nach der magnetfeldgestützten oder -nichtgestützten PVD-Technik, bei der ein die zu beschichtenden Elemente umgebendes Zerstäubungsgas in eine Vakuumkammer eingeführt wird, die eine an einen im Hochfrequenz- oder Mikrowellenbereich arbeitenden Gleich- oder Wechselstrom-Großgenerator angeschlossene metallische Auflage umschließt, auf der sich das zu beschichtende Werkstück befindet, wobei eine Entladung erzeugt wird, um eine physische und chemische Anregung des Zerstäubungsgases und dessen Ionisierung in Plasmaform zu ermöglichen, und ein Target oberflächenzerstäubt wird, das von einem die zu beschichtenden Elemente ferner umgebenden Material bzw. Legierung gebildet ist, angeordnet in der Vakuumkammer und gespeist mit Gleich- oder Hochfrequenzstrom, derart, daß auf dem Werkstück die Herstellung einer Schutzschicht von großer Härte von der Art eines amorphen PseudokohlenstoffDiamanten hervorgerufen wird, wobei das Verfahren dadurch gekennzeichnet ist, daß das Zerstäubungsgas dieses Targets 5 bis 40 % Stickstoff und 5 bis 40 % Wasserstoff sowie 0,5 bis 5 % Bor enthält, das als Katalysator wirkt, um die Verbindungen vom CH-Typ zu entspannen, damit der Wasserstoff durch Rekombination mit dem atomaren Wasserstoff und dem atomaren Stickstoff eliminiert werden kann und um die Gewinnung von CN-Verbindungen zu fördern, dem Zerstäubungsgas 10 bis 70 % eines Gemisches von Helium und Argon oder 10 bis 70 % Neon zugesetzt wird, dessen Funktion darin besteht, den Stickstoff und den Wasserstoff stark anzuregen und gleichzeitig zu dissoziieren, und die Kennlinien des Stroms, der die das Werkstück tragende Auflage speist, so gewählt werden, daß eine Hochfrequenzpolarisation der Auflage erreicht wird, die es ermöglicht, Bedingungen einzuhalten, welche den Energiebedarf definieren, für den ein Maximum an tetraederförmigen Strukturen des Diamanttyps auf Kosten hexagonaler Strukturen des Graphittyps erreicht wird.

6. Verfahren zur Herstellung einer Schutzschicht von großer Härte, auf zumindest einem Werkstück, auf der Basis von Titan, Stickstoff und Kohlenstoff nach der magnetfeldgestützten oder -nichtgestützten PVD-Technik, bei der ein die zu beschichtenden Elemente umgebendes Zerstäubungsgas in eine Vakuumkammer eingeführt wird, die eine an einen im Hochfrequenz- oder Mikrowellenbereich arbeitenden Gleich- oder Wechselstrom-Großgenerator angeschlossene metallische Auflage umgibt, auf der sich das zu beschichtende Werkstück befindet, wobei eine Entladung erzeugt wird, um eine physische und chemische Anregung des Zerstäubungsgases und dessen Ionisierung in Plasmaform zu ermöglichen, und ein Target oberflächenzerstäubt wird, das von einem Material bzw. einer Legierung gebildet wird, das/die die zu beschichtenden Elemente ferner umgibt, angeordnet in der Vakuumkammer und gespeist mit Gleich- oder Hochfrequenzstrom, um auf dem Werkstück die Herstellung einer Schutzschicht von großer Härte vom TiCN-Typ hervorzurufen, wobei das Verfahren dadurch gekennzeichnet ist, daß ein Target aus Titan oder Titannitrid zerstäubt wird, wobei das Zerstäubungsgas dieses Targets Stickstoff sowie 10 bis 70 % Wasserstoff, gebunden an einen oder mehre Kohlenwasserstoffe, und 0,5 bis 5 % Bor enthält, das als Katalysator wirkt, um die Verbindungen vom CH-Typ zu entspannen, derart, daß der Wasserstoff durch Rekombination mit dem atomaren Wasserstoff und dem atomaren Stickstoff eliminiert werden kann und die Gewinnung von CN-Verbindungen gefördert wird, dem Zerstäubungsgas 10 bis 70 % eines Gemisches von Helium und Argon oder 10 bis 70 % Neon zugesetzt wird, dessen Aufgabe darin besteht, den Stickstoff und den Wasserstoff stark anzuregen und gleichzeitig zu dissoziieren, und die Kennlinien des Stroms, der die das Werkstück tragende Auflage speist, so gewählt werden, daß eine Hochfrequenzpolarisierung der Auflage erreicht wird, die es ermöglicht, Bedingungen einzuhalten, welche den Energiebereich definieren, für den ein Maximum an tetraederförmigen Strukturen des Diamanttyps auf Kosten hexagonaler Strukturen des Graphittyps erreicht wird.

7. Verfahren zur Herstellung einer Schutzschicht von großer Härte, auf zumindest einem Werkstück, mit überwiegend tetraederförmiger Struktur, auf der Basis von Bor und Stickstoff nach der magnetfeldgestützten oder -nichtgestützten PVD-Technik, bei der ein die zu beschichtenden Elemente umgebendes Zerstäubungsgas in eine Vakuumkammer eingeführt wird, die eine an einen im Hochfrequenz- oder Mikrowellenbereich arbeitenden Gleich- oder Wechselstrom-Großgenerator angeschlossene metallische Auflage umschließt, auf der sich das zu beschichtende Werkstück befindet, wobei eine Entladung erzeugt wird, um eine physische und chemische Anregung des Zerstäubungsgases und dessen Ionisierung in Plasmaform zu ermöglichen, und ein Target oberflächenzerstäubt wird, das von einem Material bzw. einer Legierung gebildet ist, das/die ferner die zu beschichtenden Elemente umgibt, angeordnet in der Vakuumkammer und gespeist mit Gleich- oder Hochfrequenzstrom, um auf dem Werkstück die Herstellung einer Schutzschicht von großer Härte vom BN-Typ hervorzurufen, wobei das Verfahren dadurch gekennzeichnet ist, daß ein Target aus massivem Bornitrid zerstäubt wird, wobei das zerstäubungsgas dieses Targets 5 bis 40 % Stickstoff und 5 bis 40 % Wasserstoff enthält, dem zerstäubungsgas 10 bis 70 % eines Gemisches von Helium und Argon oder zwischen 10 und 70 % Neon zugesetzt wird, dessen Funktion darin besteht, den Stickstoff und den Wasserstoff stark anzuregen und gleichzeitig zu dissoziieren, und die Kennlinien des Stroms, der die das Werkstück tragende Auflage speist, so gewählt werden, daß eine Hochfrequenzpolarisierung dieser Auflage erreicht wird, die es ermöglicht, Bedingungen einzuhalten, welche den Energiebereich definieren, für den ein Maximum an tetraederförmigen Strukturen des Diamanttyps auf Kosten hexagonaler Strukturen des Graphittyps erreicht wird.

8. Verfahren nach einem der Ansprüche 1 bis 7, dadurch gekennzeichnet, daß die Bedingungen von Stärke und Druck, die im Inneren der Vakuumkammer herrschen, derart gewählt werden, daß ein Plasma mit nicht stoßbestimmter Hülle erzeugt wird, das es ermöglicht, die jedem Atom des Vorläufergases oder des Zerstäubungsgases und des zerstäubten Materials zugeführte Energie zu vergleichmäßigen.

9. Verfahren nach einem der Ansprüche 1 bis 8, dadurch gekennzeichnet, daß ein im Mikrowellenbereich arbeitender Generator eingesetzt wird.

10. Verfahren nach einem der Ansprüche 1 bis 9, dadurch gekennzeichnet, daß dem vom Generator gelieferten Strom eine Pulsierung übergelegt wird, so daß das Plasma nur während einer zyklischen Fraktion der Behandlungszeit aktiviert wird.

## Claims

1. Method for depositing on at least one component a protective coating which has a high degree of hardness, is substantially free from hydrogen, has a predominantly tetrahedral structure, and is based on carbon and nitrogen, by the PECVD technique by means of which a precursor gas containing the elements to be deposited as well as doping agents is introduced into a vacuum chamber containing a metal support which is connected to a powerful generator of direct or alternating current operating in the radio frequency or microwave range and on which the component to be coated is located, and an electric discharge is maintained inside the chamber in order to increase the temperature of the component to a value of from 150 to 400°C when the thickness of the deposit exceeds 1 µ, under conditions of temperature, power and pressure that permit the physical and chemical excitation of the precursor gas and its ionisation in the form of plasma in order to effect the deposition on the component, by ion bombardment, of a protective coating which has a high degree of hardness and which is of the pseudo amorphous carbon diamond type,
which method is characterised in that
the precursor gas contains between 10 and 70% of nitrogen associated with one or more hydrocarbons, and also from 0.5 to 5% of boron acting as a catalyst for relaxing the CH-type bonds in order to enable the hydrogen to be eliminated by recombination with the atomic hydrogen and the atomic nitrogen and to facilitate the production of CN bonds,
between 10 and 70% of a mixture of helium and argon or between 10 and 70% of neon, the role of which is strongly to excite and simultaneously to dissociate the nitrogen and the hydrogen, is added to the precursor gas, and
the energy delivered to each atom of the precursor gas is selected in such a manner as to obtain conditions that define the range of energy at which a maximum of tetrahedral structures of the diamond type is obtained at the expense of hexagonal structures of the graphite type.

2. Method according to claim 1,
characterised in that
an energy of between 100 and 150 eV is delivered to each carbon atom of the precursor gas.

3. Method for depositing on at least one component a protective coating which has a high degree of hardness, is substantially free from hydrogen and is based on titanium, nitrogen and carbon, by the PECVD technique by means of which a precursor gas containing the elements to be deposited as well as doping agents is introduced into a vacuum chamber containing a metal support which is connected to a powerful generator of direct or alternating current operating in the radio frequency or microwave range and on which the component to be coated is located, and an electric discharge is maintained inside the chamber under conditions of temperature, power and pressure that permit the physical and chemical excitation of the precursor gas and its ionisation in the form of plasma in order to effect the deposition of a protective coating which has a high degree of hardness and which is of the TiCN type,
which method is characterised in that
the precursor gas contains nitrogen, titanium and also from 10 to 70% of hydrogen associated with one or more hydrocarbons and between 0.5 and 5% of boron acting as a catalyst for relaxing the CH-type bonds in order to enable the hydrogen to be eliminated by recombination with the atomic hydrogen and the atomic nitrogen and to facilitate the production of CN bonds,
between 10 and 70% of a mixture of helium and argon or between 10 and 70% of neon, the role of which is strongly to excite and simultaneously to dissociate the nitrogen and the hydrogen, is added to the precursor gas, and
the energy delivered to each atom of the precursor gas is selected in such a manner as to obtain conditions which define the range of energy at which a maximum of tetrahedral structures of the diamond type is obtained at the expense of hexagonal structures of the graphite type.

4. Method for depositing on at least one component a protective coating which has a high degree of hardness, is substantially free from hydrogen, has a predominantly tetrahedral structure, and is based on boron and nitrogen, by the PECVD technique by means of which a precursor gas containing the elements to be deposited as well as doping agents is introduced into a vacuum chamber containing a metal support which is connected to a powerful generator of direct or alternating current operating in the radio frequency or microwave range and on which the component to be coated is located, and an electric discharge is maintained inside the chamber under conditions of temperature, power and pressure that permit the physical and chemical excitation of the precursor gas and its ionisation in the form of plasma in order to effect the deposition on the component, by ion bombardment, of a protective coating which has a high degree of hardness and which is of the BN type,
which method is characterised in that
the precursor gas contains from 10 to 70% of hydrogen and
also boron, especially diborane or also boron chloride, trimethyl boron and ammonia, as well as nitrogen,
between 10 and 70% of a mixture of helium and argon or between 10 and 70% of neon, the role of which is strongly to excite and simultaneously to dissociate the nitrogen and the hydrogen, is added to the precursor gas, and
the energy delivered to each ion of the plasma produced from the precursor gas is selected in such a manner as to obtain conditions which define the range of energy at which a maximum of tetrahedral structures of the diamond type is obtained at the expense of hexagonal structures.

5. Method for depositing on at least one component a protective coating which has a high degree of hardness, is substantially free from hydrogen, has a predominantly tetrahedral structure, and is based on carbon and nitrogen, by the PVD technique which is assisted or unassisted by a magnetic field and by means of which an atomising gas containing elements to be deposited is introduced into a vacuum chamber containing a metal support which is connected to a powerful generator of direct or alternating current operating in the radio frequency or microwave range and on which the component to be coated is located, creating a discharge in order to permit the physical and chemical excitation of the atomising gas and its ionisation in the form of plasma, and a target, which is produced from a material or an alloy also containing elements to be deposited and which is arranged in the vacuum chamber and is supplied with radiofrequency or direct current, is surface-atomised in order to effect the deposition on the component of a protective coating which has a high degree of hardness and which is of the pseudo amorphous carbon diamond type, which method is characterised in that
a graphite target is atomised,
the gas atomising that target contains between 5 and 40% of nitrogen and between 5 and 40% of hydrogen, as well as between 0.5 and 5% of boron acting as a catalyst for relaxing the CH-type bonds in order to enable the hydrogen to be eliminated by recombination with the atomic hydrogen and the atomic nitrogen and to facilitate the production of CN bonds,
between 10 and 70% of a mixture of helium and argon or between 10 and 70% of neon, the role of which is strongly to excite and simultaneously to dissociate the nitrogen and the hydrogen, is added to the atomising gas, and
the characteristics of the current supplying the support carrying the component are selected in such a manner as to obtain radiofrequency bias of the support, which enables conditions to be obtained which define the range of energy at which a maximum of tetrahedral structures of the diamond type is obtained at the expense of hexagonal structures of the graphite type.

6. Method for depositing on at least one component a protective coating which has a high degree of hardness and which is based on titanium, nitrogen and carbon, by the PVD technique which is assisted or unassisted by a magnetic field and by means of which an atomising gas containing elements to be deposited is introduced into a vacuum chamber containing a metal support which is connected to a powerful generator of direct or alternating current operating in the radio frequency or microwave range and on which the component to be coated is located, creating a discharge in order to permit the physical and chemical excitation of the atomising gas and its ionisation in the form of plasma, and a target, which is produced from a material or an alloy also containing elements to be deposited and which is arranged in the vacuum chamber and is supplied with radiofrequency or direct current, is surface-atomised in order to effect the deposition on the component of a protective coating which has a high degree of hardness and which is of the TiCN type, which method is characterised in that
a titanium or titanium nitride target is atomised, the gas atomising that target contains nitrogen, as well as from 10 to 70% of hydrogen associated with one or more hydrocarbons and from 0.5 to 5% of boron acting as a catalyst for relaxing the CH-type bonds in order to enable the hydrogen to be eliminated by recombination with the atomic hydrogen and the atomic nitrogen and to facilitate the production of CN bonds,
between 10 and 70% of a mixture of helium and argon or between 10 and 70% of neon, the role of which is strongly to excite and simultaneously to dissociate the nitrogen and the hydrogen, is added to the atomising gas, and
the characteristics of the current supplying the support carrying the component are selected in such a manner as to obtain radiofrequency bias of the support, which enables conditions to be obtained which define the range of energy at which a maximum of tetrahedral structures of the diamond type are obtained at the expense of hexagonal structures of the graphite type.

7. Method for depositing on at least one component a protective coating which has a high degree of hardness, has a predominantly tetrahedral structure, and is based on boron and nitrogen, by the PVD technique which is assisted or unassisted by a magnetic field and by means of which an atomising gas containing elements to be deposited is introduced into a vacuum chamber containing a metal support which is connected to a powerful generator of direct or alternating current operating in the radio frequency or microwave range and on which the component to be coated is located, creating a discharge in order to permit the physical and chemical excitation of the atomising gas and its ionisation in the form of plasma, and a target, which is produced from a material or an alloy also containing elements to be deposited and which is arranged in the vacuum chamber and is supplied with radiofrequency or direct current, is surface-atomised in order to effect the deposition on the component of a protective coating which has a high degree of hardness and which is of the BN type,
which method is characterised in that
a solid boron nitride target is atomised,
the gas atomising that target contains between 5 and 40% of nitrogen and between 5 and 40% of hydrogen,
between 10 and 70% of a mixture of helium and argon or between 10 and 70% of neon, the role of which is strongly to excite and simultaneously to dissociate the nitrogen and the hydrogen, is added to the atomising gas, and
the characteristics of the current supplying the support carrying the component are selected in such a manner as to obtain radiofrequency bias of the support, which enables conditions to be obtained which define the range of energy at which a maximum of tetrahedral structures of the diamond type is obtained at the expense of hexagonal structures of the graphite type.

8. Method according to any one of claims 1 to 7,
characterised in that
the conditions of power and pressure prevailing inside the vacuum chamber are selected in such a manner as to create a plasma having a non-collision sheath enabling the energy delivered to each of the atoms of the precursor gas or of the atomising gas and of the atomised material to be rendered uniform.

9. Method according to any one of claims 1 to 8,
characterised in that
a generator operating in the microwave range is used.

10. Method according to any one of claims 1 to 9,
characterised in that
a pulsation is superposed on the current supplied by the generator, so that the plasma is activated only during a cyclic fraction of the treatment time.
